# EUROPEAN PATENT APPLICATION

(11) **EP 0 856 872 A2**
(43) Date of publication of application: **05.08.1998**
(21) Application number: 98101410.3
(22) Date of filing: 27.01.1998
(51) Int. Cl.: H01L 21/00

(54) **Charged-particle-beam exposure apparatus**

(30) Priority: 27.01.1997 JP 12614/97
(71) Applicant: NIKON CORPORATION, Tokyo 100 (JP)
(72) Inventor: Morita,Kenji, Nikon Corporation, Chiyoda-ku, Tokyo 100 (JP); Nakasuji,Mamoru, Nikon Corporation, Chiyoda-ku, Tokyo 100 (JP)
(74) Representative: Meddle, Alan Leonard

(57) **Abstract**

Apparatus and methods are disclosed for increasing the throughput of a charged-particle-beam exposure apparatus while maintaining alignment and exposure accuracy. The apparatus comprises a main chamber where exposure of sensitive substrates is performed using a charged-particle beam. At least one transport system moves and prepares the sensitive substrates for exposure in the main chamber. The transport system comprises at least one chamber. An evacuation device and a venting device are used to vary the pressure in the chambers as required. At least one switching valve is situated between the main chamber and a chamber in the transport system to isolate these chambers from one another. A flexible conduit connects the main chamber to the transport system. The apparatus and methods have especial utility for the processing of sub-micron level semiconductors.

## Description

### Field of the Invention

This invention pertains to charged-particle-beam exposure apparatus used in lithography for the production of the semiconductors including integrated circuits.

### Background of the Invention

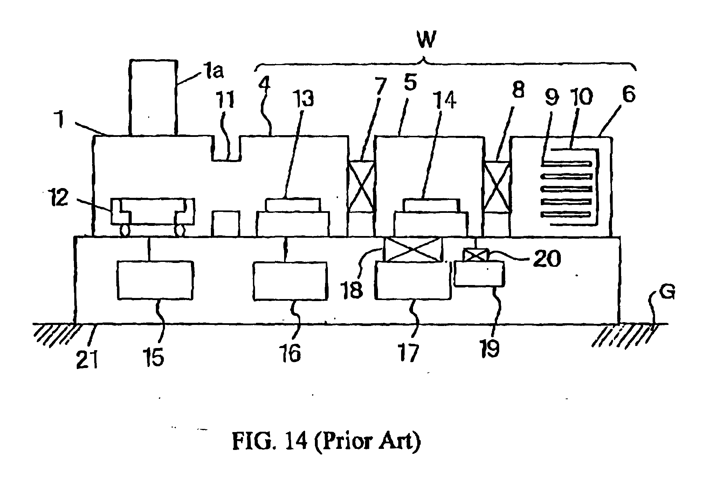

Charged-particle beams such as electron beams or ion beams have recently been considered for use in lithography exposure processes for producing of sub-micron level semiconductor integrated circuits. FIG. 14 is a schematic diagram of a conventional charged-particle-beam (CPB) exposure apparatus. The CPB exposure apparatus of FIG. 14 includes a main chamber 1 where exposures take place, and a transport system W that moves exposure substrates (wafers) into and out of the main chamber 1.

The transport system W typically comprises several chambers. Upstream of the main chamber 1 is a preparation chamber 4 where the wafers are held prior to exposure. In an atmospheric chamber 6, the interior of which is kept constantly at atmospheric pressure, several wafers 9 are loaded into a tamer cassette 10. Between the preparation chamber 4 and the atmospheric chamber 6 is a leak chamber 5 that is evacuated and vented back to atmospheric pressure whenever the wafers 9 are transported between the atmospheric chamber 6 and the preparation chamber 4.

"Switching valves" 7 and 8 (preferably gate valves) are situated between the chambers of the transport system W. The switching valve 7 connects the preparation chamber 4 and the leak chamber 5 and the switching valve 8 connects the leak chamber 5 and the atmospheric chamber 6. The main chamber 1 and the preparation chamber 4 are connected by a conduit 11. The chambers 1, 4, 5, and 6 are mounted on a single vibration-isolation member 21.

The main chamber 1 is equipped with an exposure stage 12 upon which individual wafers 9 are placed during exposure. Additionally mounted to the main chamber is a column 1a, containing the CPB source or electron optical system (not shown). The preparation chamber 4 and the leak chamber 5 have wafer holders 13 and 14 respectively. Each of the chambers 1, 4, 5 is equipped with a respective vacuum pump 15, 16, 17. The vacuum pump 17 is connected to the leak valve 5 by a valve 18. Also connected to the leak chamber 5 are a venting mechanism 19 and a leak valve 20. Wafer conveyors operable to move wafers between the chambers have been omitted for clarity.

Exposures made within the main chamber 1 are performed at a vacuum (e.g., 10⁻⁶ Torr). To such end, multiple steps are executed to transport the wafers 9 individually from atmospheric pressure in the atmospheric chamber 6 to the vacuum environment in the main chamber 1. After exposure, each wafer is moved from the main chamber 1 back to atmospheric pressure in the atmospheric chamber 6, whereupon the wafers are removed. Since these steps are repeated continually, a reference starting point is used below to describe the process. At the reference starting point the leak chamber 5 interior is at atmospheric pressure, and the switching valves 7 and 8 are in a closed position. The sequence of steps then includes:
(1) The main chamber 1 and the preparation chamber 4 are evacuated to a specific vacuum level (e.g., 10⁻⁶ Torr).
(2) Wafers 9 are loaded into the carrier cassette 10 and placed in the atmospheric chamber 6.
(3) The switching valve 8 is opened and a conveyor (not shown) removes a wafer from the carrier cassette 10 and places the wafer 9 on the wafer holder 14 of the leak chamber 5. The switching valve 8 is closed and the vacuum pump 17 evacuates the leak chamber 5 to a specified vacuum level (e.g., 10⁻⁵ Torr).
(4) After the leak chamber 5 has reached the specified vacuum level (as referenced in step (1)), the switching valve 7 is opened and the wafer 9 on the wafer holder 14 is transported to the wafer holder 13 of the preparation chamber 4, whereupon the switching valve 7 is closed.
(5) The wafer 9 in the preparation chamber 4 is transported into the main chamber 1 where the wafer is placed on the exposure stage 12 for exposure following an alignment to a specific setting.
(6) After the exposure of the wafer is complete, the exposed wafer 9 is transported back to the preparation chamber 4, whereupon the switching valve 7 is opened and the wafer 9 is transported back into the leak chamber 5.
(7) The switching valve 7 is then closed, and the leak valve 20 is opened, allowing the leak chamber 5 to return to atmospheric pressure. The switching valve 8 is then opened and the wafer 9 is returned to the carrier cassette 10 in the atmospheric chamber 6.

The foregoing series of steps is carried out sequentially on individual wafers 9 in the carrier cassette 10.

Because extremely minute measurements and operations are carried out during the exposure in the main chamber 1, the entire exposure apparatus of FIG .14 is mounted on a vibration-isolation member 21 that isolates the exposure apparatus from vibrations arising from a "machine bed" G on which the platform 21 rests, that could adversely affect the exposure accuracy. (As used herein, a "machine bed" encompasses floor, platforms, bases, and analogous rigid structures on which process machinery is normally mounted for support).

Although transmission of vibration arising from the machine bed G is reduced by the vibration-attenuating features of the vibration-isolation member 21, a significant level of vibration can be adversely transmitted to the main chamber 1 whenever the vacuum pump 17 is used to evacuate the leak chamber 5, and/or whenever the switching valves 7, 8 are opened or closed. This vibration can be transmitted to the main chamber 1 via the conduit 11 and/or via the vibration-isolation member 21. For this reason, it has been standard practice not to permit any of the foregoing steps to occur at any time during which the wafer in the main chamber 1 is being aligned, exposed, or positioned for exposure. Thus, while alignment and exposure processing are occurring in the main chamber 1, other wafers 9 cannot be transported within or between the other chambers, and the leak chamber 5 cannot be evacuated. Because of such constraints, the conventional apparatus of FIG. 14 has a low throughput.

The conventional apparatus of FIG. 14 also exhibits a wall-surface distortion in the leak chamber 5 due to the different levels of internal and external pressure applied to the chamber walls each time the leak chamber 5 is evacuated or vented back to atmospheric pressure. This wall-surface distortion can be transmitted through the switching valve 7, the preparation chamber 4, and the conduit 11 to adversely effect the accuracy of the alignment and exposures carried out in the main chamber 1.

### Summary of the Invention

In view of the foregoing shortcomings of the conventional apparatus, an object of this invention is to provide a charged-particle-beam (CPB) exposure apparatus exhibiting higher throughput without reducing the accuracy of the alignment or exposure. The invention is exemplified by several apparatus embodiments that accomplish this object by effectively isolating the main chamber from vibrations caused by processing activities occurring in adjacent chamber(s) of one or more transport systems. Thus, alignment, exposure, and transport operations can occur simultaneously without adverse effect on the accuracy of the alignments and exposures, thereby increasing throughput.

According to one aspect of the invention, a CPB exposure apparatus is provided that comprises a main chamber where alignment and exposure of sensitive substrates (e.g., wafers) are performed using a charged-particle beam. The apparatus comprises a first transport system for moving the sensitive substrates into and out of the main chamber. The transport system comprises a first chamber, an evacuation device that creates a specified vacuum level in the main chamber and in the first chamber, and a venting device for venting the pressure in the first chamber to atmospheric pressure. The apparatus also comprises a first switching valve located between the main chamber and the first chamber. The apparatus further comprises a "flexible conduit" connecting the main chamber to the first chamber. "Flexible" as used herein means that the subject conduit inhibits an attenuation of vibration transmitted though the conduit from one end to the other.

The main chamber and the transport system are preferably mounted on separate vibration-isolation members. A "vibration-isolation member" as used herein encompasses a surface, frame, platform, plate, chassis, or analogous structure that provides a mounting body for devices attached thereupon, and exhibits vibration-damping characteristics for the purpose of attenuating vibrations transmitted from a machine bed or other source to device(s) mounted upon the vibration-isolation member.

The first chamber of the transport system can be a leak chamber, and the transport system can further comprise a preparation chamber between the leak chamber and the main chamber, and an atmospheric chamber upstream of the leak chamber. The atmospheric and leak chambers, and the leak and preparation chambers are preferably separated from each other by switching valves. The switching valves provide an airtight seal when closed, effectively isolating the chambers of the transport system from one another. When open, each switching valve allows transport of a sensitive substrate through the valve from chamber to chamber.

The evacuation device can comprise a first vacuum pump for evacuating the main chamber and the preparation chamber, and a second vacuum pump for evacuating the leak and preparation chambers. A leak valve can be used to return selected chambers to atmospheric pressure as required. The flexible conduit (as summarized above), preferably including a damping device, is used to connect the main chamber to the preparation chamber (if present).

A CPB exposure apparatus according to the invention can additionally comprise a second transport system, preferably identical to the first transport system. The chambers and valves of the first and second transport systems are preferably symmetrically placed about and connected to the main chamber. Thus, processing activities in each transport system can occur simultaneously; e.g., evacuation of the preparation chambers, venting of the leak chambers, opening and closing the switching valves, etc. This creates a vibration-canceling effect: vibrations created by the evacuation, venting, and transport activities occurring simultaneously in the first and second transport systems are canceled out. To accomplish such simultaneous operation, switching of valves in the first and second transport systems is preferably sequenced by a controller.

The chambers of a single transport system can be mounted to modules individually affixed to a machine bed, with the main chamber mounted on a separate vibration-isolation member.

A mass can be affixed to or contact the flexible conduit connecting the main chamber to the transport system. The mass is sufficient to dampen any vibration of the flexible conduit and is preferably separately affixed or mounted to the machine bed.

Exposures of wafers in the main chamber can he made by moving a mask relative to the wafer during periods of continuous motion, separated by periods of no motion. A controller can be used to regulate the action of the switching valves so that valve switching only occurs during periods of no motion.

The foregoing and additional features and advantages of the invention will be more readily apparent from the following detailed description, which proceeds with reference to the accompanying drawings.

### BRIEF DESCRIPTION OF THE DRAWINGS

FIG. 1 is a schematic diagram showing a first example embodiment of a charged-particle-beam (CPB) exposure apparatus according to the invention.

FIG. 2 is a process flow diagram showing a representative exposure procedure performed using the FIG.-1 embodiment.

FIGS. 3(a)-3(d) are plan views of the FIG.-1 embodiment performing certain respective steps of the process shown in FIG. 2.

FIG. 4 is a process flow diagram showing a representative exposure procedure performed using a conventional exposure apparatus.

FIG. 5 is a schematic diagram showing an alternative configuration of the first example embodiment.

FIG. 6 is a schematic diagram showing a second example embodiment of a CPB exposure apparatus according to the invention.

FIG. 7 is a flow process diagram showing a representative exposure sequence performed using the FIG.-6 embodiment.

FIGS. 8(a)-8(c) are plan views of the FIG.-6 embodiment performing certain representative steps of the pass shown in FIG. 7.

FIG. 9 is a plan view of an alternative configuration of the second example embodiment.

FIG. 10 is a schematic diagram showing a third example embodiment of a CPB exposure apparatus according to the invention.

FIG. 11 is a schematic diagram showing a fourth example embodiment of a CPB exposure apparatus according to the invention.

FIG. 12 is a schematic elevational diagram showing a representative configuration of components inside of the FIG.-11 embodiment

FIG. 13 shows the relationship between the mask 50 and the wafer 9 of the apparatus of FIG. 12.

FIG 14 is a schematic diagram showing a conventional CPB exposure apparatus.

### DETAILED DESCRIPTION

This invention is described below in connection with multiple example embodiments which represent the current best mode of the invention.

### Example Embodiment 1

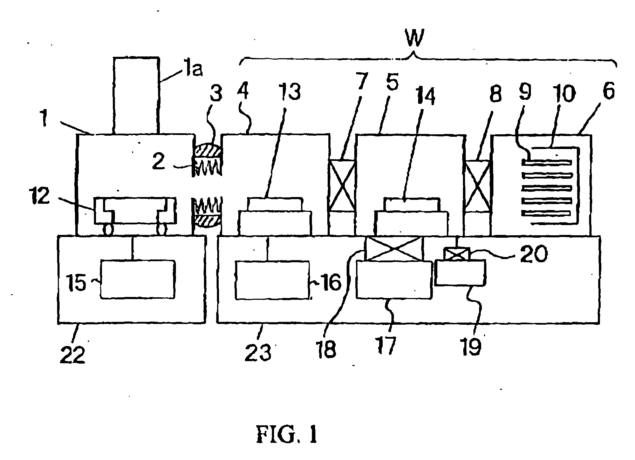

A charged-particle-beam (CPB) expose apparatus according to this example embodiment is shown in FIG. 1. The FIG.-1 embodiment comprises certain components that are similar to those shown in FIG. 14. Such components have the same reference designators as corresponding components shown in FIG. 14.

In FIG. 1 the main chamber 1 is mounted on a first vibration-isolation member 22, and all components of the transport system W (including the preparation chamber 4, the leak chamber 5, and the atmospheric chamber 7) are mounted on a second vibration-isolation member 23. The main chamber 1 and the preparation chamber 4 are connected to each other by a flexible conduit 2 (preferably a bellows or analogous component). The flexible conduit 2 is preferably equipped with a damper 3 (preferably an elastomeric sheath enclosing the flexible conduit 2).

The flexible conduit 2 replaces the fixed conduit 11 used in the conventional apparatus (FIG. 14) to connect the main chamber 1 with the preparation chamber 4. The flexible conduit 2 reduces vibration conveyed to the main chamber 1 from the preparation chamber 4 (especially vibration arising from the opening and closing motion of the switching valves 7 and 8 and/or from operation of the vacuum pump 16 and 17). By additionally employing the damper 3, this vibration can be attenuated even more effectively.

To minimize transmission of vibration from the transport system W to the main chamber 1, the main chamber 1 in this embodiment is mounted on the first vibration-isolation member 22, which is separate from the second vibration-isolation member 23 upon which the transport system W is mounted. Such separate mounting of the main chamber from the transport system W, and the use of the flexible conduit 2 (preferably with damper 3) attenuates transmission of vibration to the main chamber 1 such that alignment and exposure accuracy are not adversely affected. This allows transport operations to be performed during alignment and exposure operations, thereby increasing throughput.

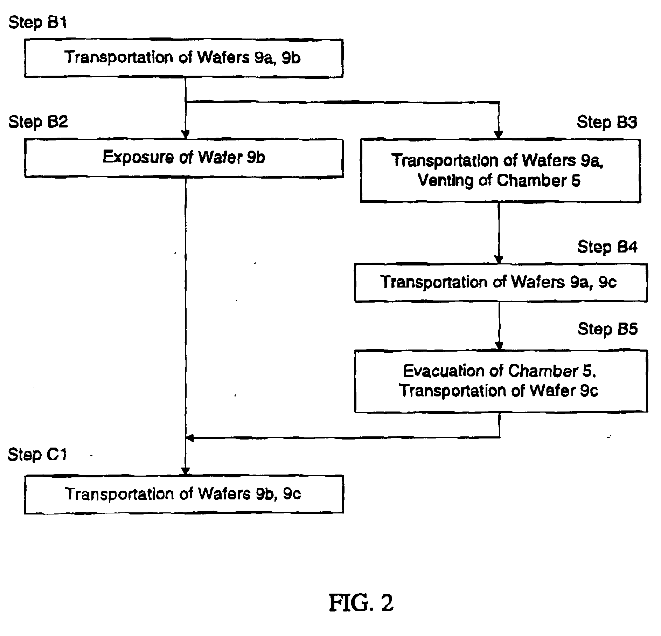

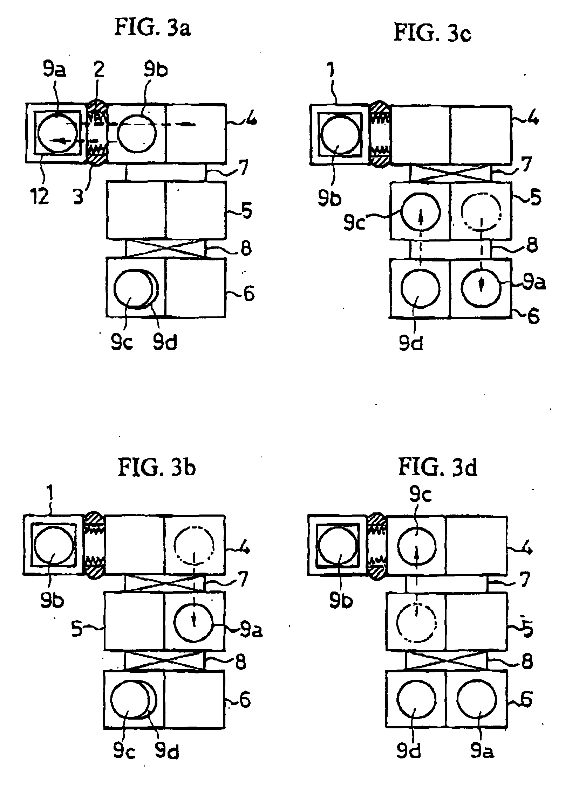

FIG. 2 shows a representative exposure procedure performed using the FIG.-1 embodiment FIGS. 3(a)-3(d) are plan views of the FIG.-1 embodiment used to illustrate certain steps of the process shown in FIG. 2. For clarity FIGS. 3(a)-3(d) show the processing of only four wafers 9a-9d; the FIG.-1 embodiment can process more than four wafers at a time.

As shown in FIG. 3(a), the wafer 9b is transported into the preparation chamber 4 while wafers 9c and 9d are held in a carrier cassette 10 (see FIG. 1; not shown in FIG. 3(a)) in the atmospheric chamber 6. Since processing is continuous, a starting point will be selected to better describe the process. At this starting point exposure of wafer 9a in the main chamber 1 is complete. In FIGS. 3(a)-3(d), the absence or presence of an "x" inside the switching valves 7 and 8 indicates whether they are open or closed, respectively. In the step shown in FIG. 3(a), the switching valve 8 is closed, the switching valve 7 is open, and the chambers 1, 4 and 5 have been evacuated, while the chamber 6 is at atmospheric pressure.

In step B1 in FIG. 2, exposure of the wafer 9a has been completed and the wafer 9a is being transported into the preparation chamber 4, while the wafer 9b is being transported from the preparation chamber 4 into the main chamber 1 as indicated by the dashed arrows in FIG. 3(a). In step B2, the wafer 9b is being aligned and exposed in the main chamber 1.

In this example embodiment, steps B3 through B5, described below, are executed at the same time as the step B2. In step B3 (see FIG. 3(b)), after the wafer 9a has been transported from the preparation chamber 4 into the leak chamber 5, the switching valve 7 is closed and the leak chamber 5 is vented, thus returning the leak chamber 5 to atmospheric pressure. In step B4 (see FIG. 3(c)), the switching valve 8 is opened and the wafer 9a is transported from the leak chamber 5 into the atmospheric chamber 6 and the wafer 9c is transported from the atmospheric chamber 6 into the leak chamber 5. In step B5 (see FIG. 3(d)), the switching valve 8 is closed and, after the leak chamber 5 has been evacuated to a predetermined vacuum level by the vacuum pump 17 (see FIG. 1), the switching valve 7 is opened and the wafer 9c is transported from the leak chamber 5 into the preparation chamber 4.

In the net step Cl, the wafers in the preparation chamber 4 and the main chamber 1 are exchanged, with the wafer 9c being transported into the main chamber 1 and the wafer 9b being transported into the preparation chamber 4, respectively. This is similar to step B1. Thereafter, the steps B2 to B5 are executed in the same fashion on the wafer 9b. The same steps are repeated for wafers 9c and 9d and subsequent wafers. In sum, this embodiment provides for continuous stepped processing, with unprocessed wafers being added to the atmospheric chamber 6 as processed wafers are being removed from this chamber upon completion of processing.

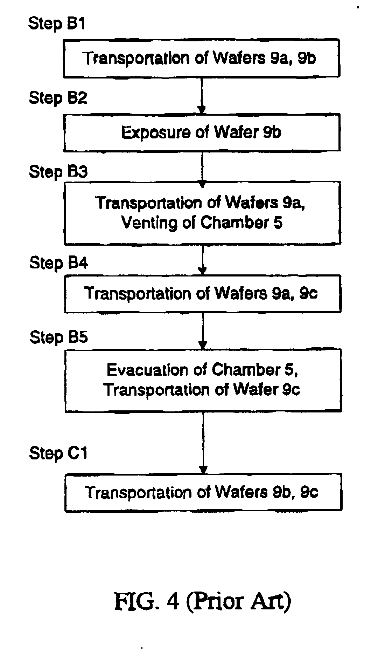

For comparison, FIG. 4 shows a representative exposure process sequence performed using the conventional CPB exposure apparatus shown in FIG. 14. The steps shown in FIG. 4 are identical to the steps shown in FIG. 2 and discussed above. However, in a conventional exposure apparatus, exposure steps cannot be executed simultaneously with other steps. This is illustrated in FIG. 4, in which the steps B1 through B5 are executed in a series fashion.

The vibration-reduction techniques employed in this example embodiment reduce the vibration transmitted from the transport system W to the main chamber 1 sufficiently to allow step B2 and steps B3 - B5 to be executed simultaneously, thereby improving the overall throughput of the system without degrading alignment or exposure accuracy.

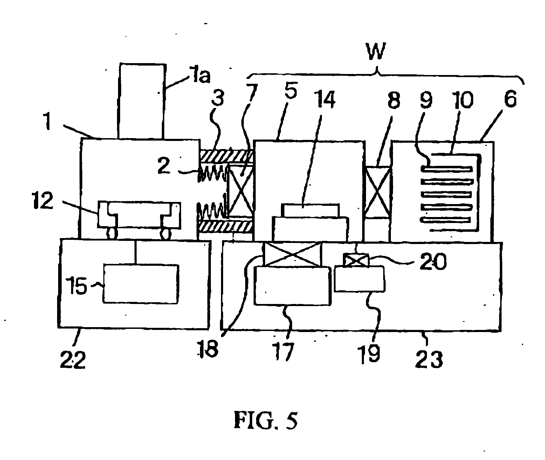

The FIG.-1 embodiment includes no switching valve between the main chamber 1 and the preparation chamber 4. However, the preparation chamber 4 can be deleted as shown in the alternative configuration of FIG. 5. In the FIG.-5 configuration, the main chamber 1 is connected via the flexible conduit 2 to the leak chamber 5, and the switching valve 7 is preferably situated between the flexible conduit 2 and the leak chamber 5. Thus, the flexible conduit 2 attenuates vibration that would otherwise be transmitted to the main chamber 1 during actuation of the switching valve 7.

### Example Embodiment 2

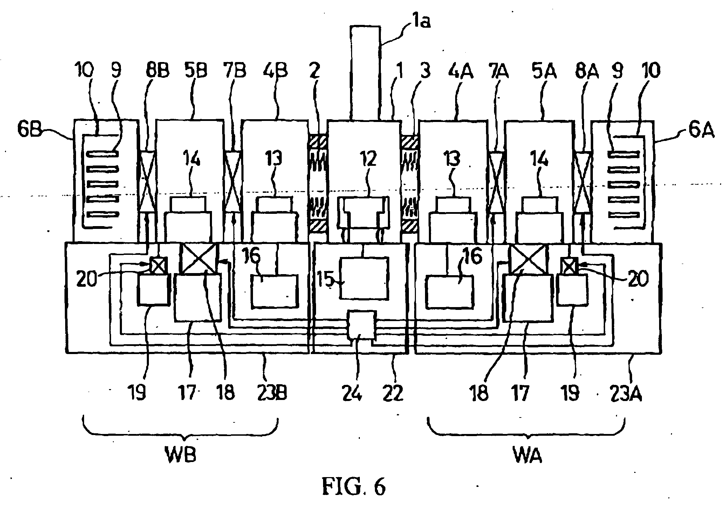

FIG. 6 depicts a CPB exposure apparatus according to this example embodiment. In FIG. 6, components that are similar to corresponding components shown in FIG. 1 have the same reference designators and are not described further.

The FIG.-6 embodiment comprises two transport systems, WA and WB, in contrast to the single transport system employed in the first example embodiment. In FIG. 6, the transport system WA is used to transfer wafers into the main chamber 1 for exposure. The transport system WA comprises a preparation chamber 4A, a leak chamber 5A, an atmospheric chamber 6B, and a vibration-isolation member 23A. The transport system WB is symmetrical to the transport system WA, and is used to transport exposed wafers from the main chamber 1. The transport system WB comprises a preparation chamber 4B, a leak chamber 5B, an atmospheric chamber 6B, and a vibration-isolation member 23B. Each of these components has the same functions as the corresponding components (the preparation chamber 4, the leak chamber 5, the atmospheric chamber 6, and the vibration-isolation member 23) of the flat example embodiment. Similarly, the functions of the switching valves 7A, 7B, 8A, 8B, 18, and 20 are analogous to the respective functions of the switching valves 7, 8, 18, and 20 of the first example embodiment. In the FIG.-6 embodiment, the switching action of valves 7A through 8B, 18, and 20 are controlled by a controller 24.

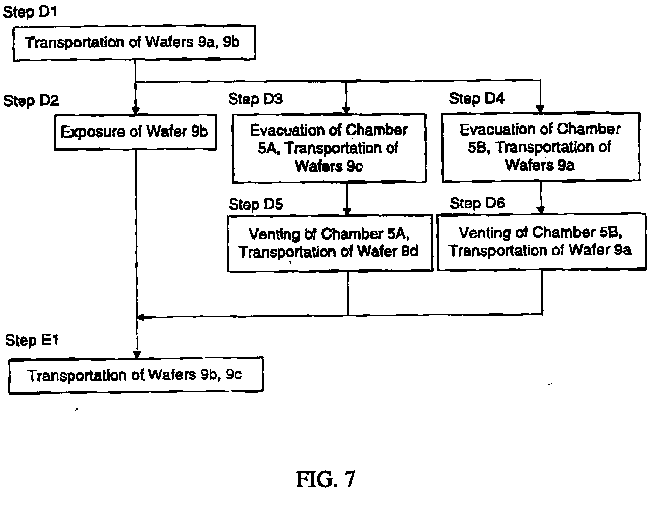

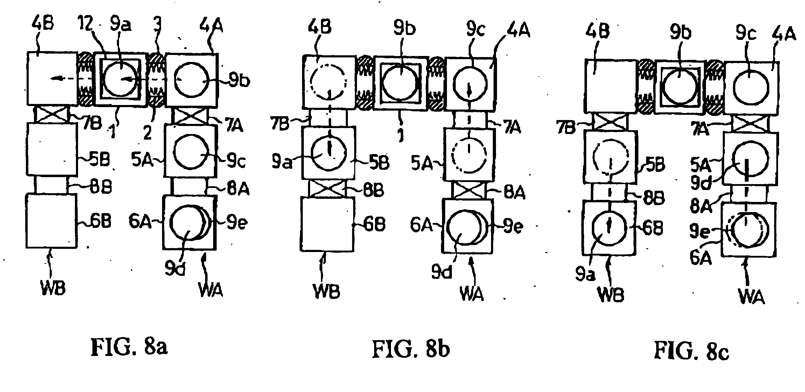

The exposure procedure for the second example embodiment is discussed below with reference to FIGS. 7 and 8(a)-8(c). FIG. 7 shows a process that is similar in certain aspects to that shown in FIG. 2. FIGS. 8(a)-8(c) is a plan view of the exposure apparatus of example embodiment 2, illustrating wafer movements and valve positions corresponding to certain steps illustrated in FIG. 7. In FIGS. 8(a)-8(c), the transport systems WA and WB are placed symmetrically with respect to the main chamber 1 in a "U" shape.

As with the first example embodiment, the process sequence for the second example embodiment will be described beginning with the completion of the exposure of the wafer 9a, as illustrated by FIG. 8(a). During this initial step the switching valves 8A and 8B are open, the switching valves 7A and 7B are closed, the chambers 1, 4A, and 4b are evacuated, and the chambers 5A, 5B, 6A and 6B are at atmospheric pressure.

As indicated by the dashed arrows in FIG. 8(a), the exposed wafer 9a is being transported into the preparation chamber 4B while the wafer 9b in the preparation chamber 4A is being simultaneously transported into the main chamber 1. In the step D2 (see FIG. 7), the wafer 9b is exposed in the main chamber 1.

Steps D3 through D6 are executed simultaneously with step D2. FIG 8(b) shows steps D3 and D4. In step D3, the switching valve 8A is closed and, after the leak chamber 5A has been evacuated, the switching valve 7A is opened and the wafer 9c is transported into the preparation chamber 4A. In step D4, executed simultaneously with step D3, the switching valve 8B is closed and, after the leak chamber 5B has been evacuated, the switching valve 7B is opened and the wafer 9a is transported from the preparation chamber 4B into the leak chamber 5B.

FIG. 8(c) depicts steps D5 and D6. In step D5, after closing the switching valve 7A, the leak chamber 5A is vented back to atmospheric pressure, the switching valve 8A is opened, and the wafer 9d in the atmospheric chamber 6A is transported into the leak chamber 5A. In step 6D, which is executed simultaneously with step D5, after closing the switching valve 7B, the leak chamber 5B is vented back to atmospheric pressure, the switching valve 8B is opened, and the wafer 9a is transported into the atmospheric chamber 6B. During the subsequent step E1, the wafers 9b and 9c are exchanged, with wafer 9b being transported into the preparation chamber 4B and the wafer 9c being transported into the main chamber 1 (this is equivalent to step D1 except that now different wafers are being used). Thereafter, the same sequence of processing steps as is described above in steps D2 through D6 are executed on wafer 9b, and subsequently on additional wafers in sequence, thereby providing a continuous stepped process.

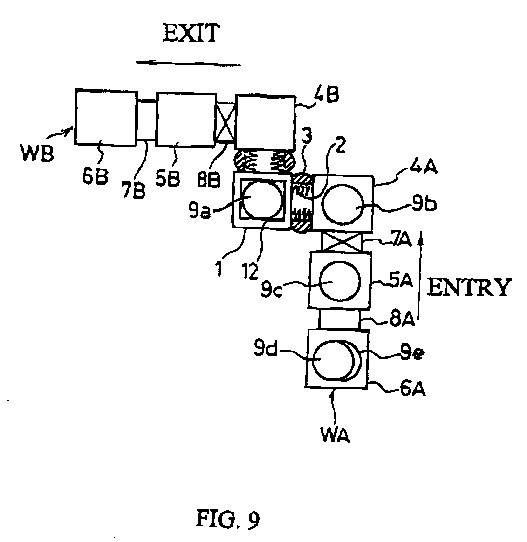

In FIGS. 8(a)-8(c), the positions of the preparation chamber 4A of the transport system WA and the preparation chamber 4B of the transport system WB are bilaterally symmetrical with respect to the main chamber 1. This arrangement is not limiting; FIG. 9 depicts an alternative configuration in which the preparation chambers 4A and 4B could be placed at 90-degree angles to the main chamber 1. Other alternative configurations may also be used, depending on the device layout requirements, so long as the exposure procedure is the same as for the procedure shown in FIGS. 7 and 8(a)-8(c).

In this example embodiment, the evacuation in steps D3 and D4 is performed simultaneously as described above, and the opening and closing of the valves 17A, 17B, 18A, 18B, and 20 is controlled by the controller 24 so that the leak-chamber operation in steps D5 and D6 will occur simultaneously. In this example embodiment, as in the first example embodiment, the transportation steps (steps D3 through D6) occur simultaneously with alignment and exposure (step D2), thereby improving throughput.

This example embodiment also provides additional benefits due to the arrangement of the chambers and timing of the valve sequencing. As shown in FIG. 8, the leak chambers 5A and 5B are preferably placed symmetrically with respect to the main chamber 1. By simultaneously performing evacuation and venting of these chambers, any wall-surface distortion effects on the main chamber are canceled out, greatly attenuating any adverse effect on alignment and exposure.

### Example Embodiment 3

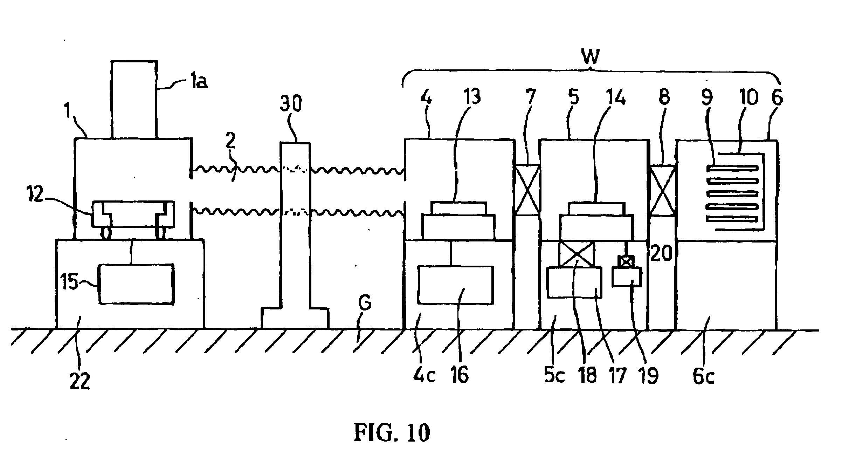

A CPB exposure apparatus according to this example embodiment is depicted in FIG. 10. In FIG. 10, components similar to corresponding components shown in FIG. 1 have the same reference designators and are not described further. In this example embodiment the preparation chamber 4, the leak chamber 5, and the atmospheric chamber 6 are mounted to the machine bed G by respective fixed modules 4c, 5c, and 6c. The main chamber 1 is mounted on a separate vibration-isolation member 22 that reduces transmission of vibrations from the machine bed G to the main chamber.

The flexible conduit 2 connecting the main chamber 1 with the preparation chamber 4 passes through or is attached to a mass 30 that anchors the flexible coupling 2 to the machine bed G and attenuates any vibration transmitted from the transport system W through the flexible conduit 2 to the main chamber 1. For this reason, exposures occurring in the main chamber 1 and transportation of a wafer 9 by the transport system W can be executed simultaneously. An additional advantage is that this example embodiment does not require a vibration-isolation member for the entire transport system W, thereby lowering the overall system cost.

### Example Embodiment 4

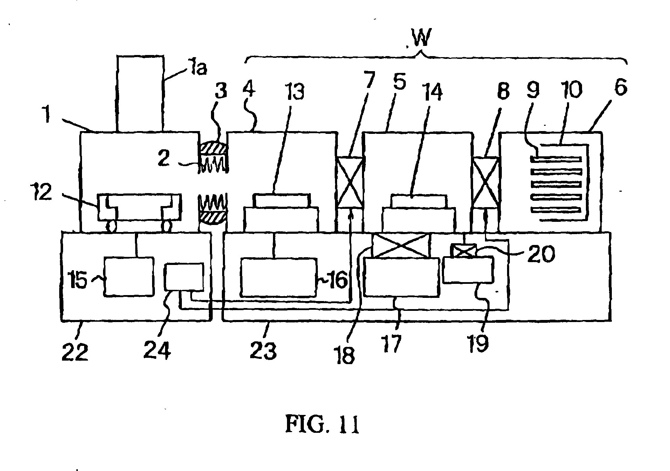

An electron-beam projection apparatus according to this example embodiment is shown in FIG. 11. This example embodiment differs from the first example embodiment by comprising a controller 24 that sequences the opening and closing of switching valves 7 and 8 based on the timing of wafer alignment and exposure occurring in the main chamber 1. Components similar to corresponding components shown in FIG. 1 have the same reference designators and are not described further.

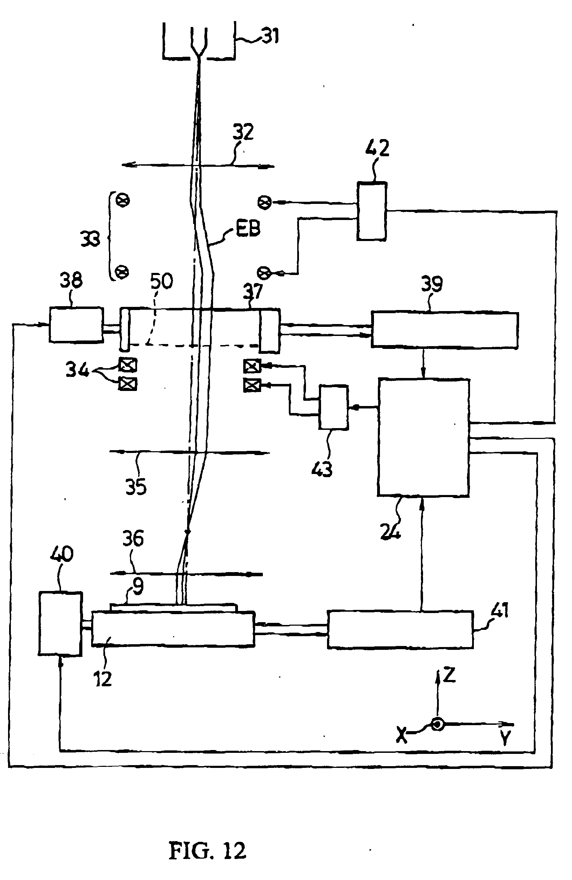

FIG. 12 schematically shows exposure components inside the main chamber 1. An electron beam EB emitted from an electron gun 31 is collimated by a condenser lens 32, laterally deflected by a subfield-selection deflector 33, and guided to a preselected subfield (described below) of a mask 50. After passing through the mask 50, the electron beam EB is deflected by a deflector 34 (sufficiently to impinge upon a "transfer subfield" on a wafer 9 corresponding to the respective mask subfield.) The electron beam is then reduced by a specific amount and imaged on the respective transfer subfield on the wafer 9 by lenses 35, 36. The mask 50 is mounted to a mask stage 37 parallel to the xy plane. During exposure, the mask stage 37 is moved continuously in the x-axis direction by a driver 38 and "stepped" in the y-axis direction.

The wafer 9 is mounted to a water stage 12 parallel to the xy plane. During exposure, the wafer stage 12 is moved continuously in the x-axis direction by a driver 40 and "stepped" in the y-axis direction. Because the lenses 35 and 36 reverse the pattern image, the direction of continuous movement and of stepping motion of the wafer stage 12 during exposure are opposite the directions of respective motions of the mask stage 37. The position within the xy plane of the wafer stage 12 is detected by a laser interferometer 41 that produces a corresponding output to the controller 24. Power supplies 42, 43 provide power for the deflectors 33, 34, respectively, and are controlled by the controller 24.

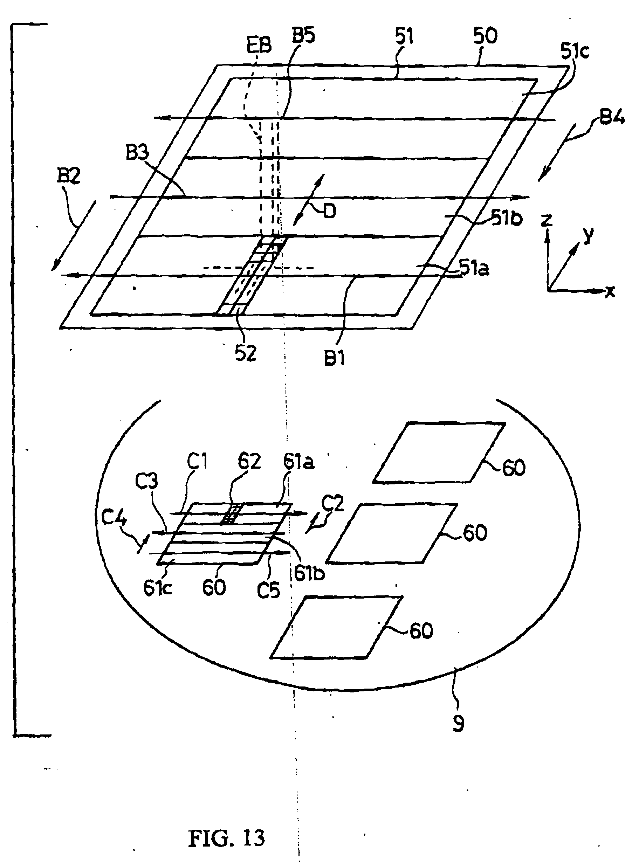

The relationship between the mask 50 and the wafer 9 during exposure is shown in FIG. 13. The wafer 9 normally accommodates multiple "dies" 60 each representing a region on which an exposure of the mask pattern is made. The pattern area 51 of the mask 50 is divided into sections 51a, 51b, 51c longitudinally in the direction of continuous motion (x-axis direction) of the mask 50. Each of the sections 51a-51c is further divided into smaller areas ("mask subfields") 52. In the same way, each of the dies 60 of the wafer 9 is also divided up into sections 61a-61c corresponding to the respective sections 51a-51c. Each of the sections 61a-61c is further divided into smaller areas ("transfer subfields") 62.

The mask 50 pattern is exposed onto each die 60 of the wafer 9 in a single continuous and coordinated motion of the mask 50 and the wafer 9. Each mask subfield 52 in the sections 51a-51c is sequentially projected onto the corresponding transfer subfield in the sections 61a-61c. In FIG. 13, for example, mask subfields in the section 51a are projected in sequential order, in the negative x direction as indicated by the arrow B1, while the wafer 9 is simultaneously moved continuously in the positive x direction as indicated by the arrow C1. Meanwhile, the electron beam EB is deflected in the y direction as indicated by the arrow D and each of the mask subfields 52 of the section 51a is scanned in order, in a zigzag fashion from the left side to the right side in the diagram. When exposure of the area 51a is completed in this way, the mask 50 is stepped in the B2 direction (negative y direction) and the wafer 9 is stepped in the C2 direction (positive y direction). Next, while continuously moving the mask 50 in the B3 direction (positive x direction) and the wafer 9 in the C3 direction (negative x direction), the electron beam EB is deflected onto each of the mask subfields 52 of the section 51b. After the exposure of the section 51b has been completed, the mask 50 is moved in the B4 direction (negative y direction) and the wafer 9 is stepped in the C4 direction (positive y direction). Then, the exposure is performed while continuously moving the mask 50 in the B5 direction (negative x direction) and the wafer 9 in the C5 direction (positive x direction).

By repeating the series of exposure steps described above, the entire pattern of the mask 50 is exposed onto each die 60 of the wafer 9. In order to control the principal source of vibration in this embodiment, the controller 24 controls the opening and closing action of the switching valves 7 and 8 (see FIG. 11), so that such actions occur between the times when the exposure of one die 60 has been completed and the exposure of another die 60 is begun, thereby not affecting pattern-exposure accuracy while the mask 50 and the wafer 9 are being stepped. In this way, throughout the entire exposure process of the wafer 9, exposures are made continuously and the switching valves 7 and 8 are opened and closed between exposures of successive dies so that the effect of vibration on the accuracy of the exposure remains minimal.

In any of the foregoing example embodiments, the vacuum pumps 15-17 and the valve 18 represent "evacuation devices," and the venting mechanism 19 and the leak valve 20 represent "venting devices."

Example materials for certain of the aforementioned components are as follows. The flexible conduit 2 can be any suitable flexible material, including a metal such as copper or stainless steel, a fabric, a composite material, or an elastomeric material, and can have any suitable configuration such as (but not limited to) a bellows. The damper 3 may be made of an elastomer such as rubber, or any of various other materials having sufficient vibration-dampening characteristics. The vibration-isolation members and the like can be those typically used in the semiconductor processing industry. The chambers, switching valves, vacuum pumps, and transport equipment can be standard components as used in the semiconductor processing industry.

While the present invention has been described in connection with preferred embodiments, it will be understood that the invention is not limited to those embodiments. On the contrary, the invention is intended to cover all alternatives, modifications, and equivalents as may be included within the spirit and scope of the invention as defined in the appended claims.

## Claims

1. A charged-particle-beam exposure apparatus, comprising:
(a) a main chamber where exposure of sensitive substrates is performed using a changed particle beam;
(b) a first transport system for moving the sensitive substrates from outside the main chamber to inside the main chamber for exposure, the first transport system comprising a first chamber;
(c) an evacuation device that creates a desired vacuum level in the main chamber and in the first chamber;
(d) the first transport system comprising a venting device for venting the pressure in the first chamber to atmospheric pressure;
(e) a first switching valve located between the main chamber and the first chamber; and
(f) a flexible conduit connecting the main chamber to the first chamber.

2. The charged-particle-beam exposure apparatus of claim 1, wherein the first chamber is a leak chamber.

3. The charged-particle-beam exposure apparatus of claim 2, wherein the evacuation device comprises a first vacuum pump connected to the main chamber and a second vacuum pump connected to the leak chamber.

4. The charged-particle-beam exposure apparatus of claim 2, wherein the first transport system further comprises:
a preparation chamber, located between the main chamber and the leak chamber, and an atmospheric chamber located upstream of the leak chamber; and
a second switching valve located between the atmospheric chamber and the leak chamber, wherein the first switching valve is located between the leak chamber and the preparation chamber.

5. The charged-particle-beam exposure apparatus of claim 1, further comprising independent first and second vibration-isolation members, the first vibration-isolation member mounting the first transport system to a machine bed, and the second vibration-isolation member mounting the main chamber to the machine bed.

6. The charged-particle-beam exposure apparatus of claim 1, wherein the first switching valve is located between the flexible conduit and the first chamber.

7. The charged-particle-beam exposure apparatus of claim 1, further comprising a damper contacting the flexible conduit.

8. The charged-particle-beam exposure apparatus of claim 7, wherein the damper comprises an elastomeric sheath through which the flexible conduit extends.

9. The charged-particle-beam exposure apparatus of claim 1, further comprising a second transport system for moving the sensitive substrates out of the main chamber.

10. The charged-particle-beam exposure apparatus of claim 9, wherein:
each of the first and second transport systems comprises a respective evacuation device and a respective leak chamber; and
the first and second transport systems being connected to the main chamber such that each of the leak chambers is placed symmetrically with respect to the main chamber.

11. The charged-particle-beam exposure apparatus of claim 10, further comprising a controller for controllably actuating evacuation and venting operations of each of the leak chambers so that the evacuation and venting operations of the leak chambers occur simultaneously.

12. The charged-particle-beam exposure apparatus of claim 1, wherein the main chamber is mounted on a vibration-isolation member mounted to a machine bed, and each chamber of the first transport system is separately mounted on an independent module mounted to the machine bed.

13. The charged-particle-beam exposure apparatus of claim 1, further comprising a mass contacting the flexible conduit between the main chamber and the first transport system, the mass being independent of the main chamber.

14. The charged-particle-beam exposure apparatus of claim 1, further comprising a vibration attenuator placed between the main chamber and the first transport system.

15. A method for increasing throughput of a charged-particle-beam exposure apparatus, wherein exposure of a sensitive substrate by a charged-particle beam occurs in a main chamber, and exposure of the sensitive substrate occurs by a sequence of exposure events including motion periods in which the sensitive substate is moving and quiescent periods in which the sensitive substrate is not moving, the method comprising the steps:
(a) providing a transport system connected to the main chamber, comprising a transport-system chamber and a switching valve that when actuated to an open position allows movement of a sensitive substrate through the transport system and when actuated to a closed position blocks movement of the sensitive substrate through the transport system; and
(b) during exposure of the sensitive substrate, controllably actuating the switching valve during the quiescent periods, so as to reduce vibration being transmitted to the sensitive substrate during the exposure.
